# EUROPEAN PATENT APPLICATION

(11) **EP 4 693 595 A1**
(43) Date of publication of application: **11.02.2026**
(21) Application number: 24806990.8
(22) Date of filing: 23.04.2024
(51) Int. Cl.: H01M 10/42, H01M 10/48, H02J 13/00

(54) **DATA PROCESSING SYSTEM, CONNECTION BOX, AND DATA PROCESSING METHOD**

(30) Priority: 15.05.2023 JP 2023080350
(71) Applicant: GS Yuasa International Ltd., Kisshoin, Minami-ku, Kyoto-shi, Kyoto 601-8520 (JP)
(72) Inventor: OHMAE, Takao, Kyoto-shi, Kyoto 601-8520 (JP)
(74) Representative: Isarpatent
(86) International application number: PCT/JP2024/015867
(87) International publication number: WO 2024/237036

(57) **Abstract**

A data processing system includes a plurality of storage units each including a control device that controls charge-discharge of a plurality of energy storage devices, and a data processing device, in which the plurality of storage units are provided at different places, each of the plurality of storage units is capable of storing a plurality of energy storage devices, the data processing device includes a memory that stores state data of the plurality of energy storage devices, and a processor that updates the state data stored in the memory by using a state data of the plurality of energy storage devices received from the control device, and the processor derives a quality evaluation of each of the plurality of energy storage devices on the basis of the state data stored in the memory, and outputs the derived quality evaluation to the control device or another device.

## Description

### TECHNICAL FIELD

The present invention relates to a data processing system, a connection box, and a data processing method for managing an energy storage device.

### BACKGROUND ART

Deterioration in an energy storage device such as a lead-acid battery or a lithium ion secondary battery progresses even in a period in which the energy storage device is not used. An energy storage device is not used from the time it is manufactured by a manufacturer until shipped, or from the time it is shipped from the manufacturer until transferred to a user and started to be used. When an energy storage device remains completely discharged for a long period from the manufacture to the start of use, the energy storage device cannot exhibit the performance assumed at the time of manufacture.

Patent Document 1 discloses that a battery group stored in a storage of used batteries is used in an energy storage system even during a storage period. Patent Document 1 discloses a method of configuring an assembled battery from battery groups having similar deterioration states, and curbing charge-discharge for a battery group with a lower degree of deterioration so that deterioration does not progress.

### PRIOR ART DOCUMENT

### PATENT DOCUMENT

Patent Document 1: JP-A-2022-147158

### SUMMARY OF THE INVENTION

### PROBLEMS TO BE SOLVED BY THE INVENTION

An object of the present invention is to provide a data processing system, a connection box, and a data processing method for achieving quality assurance and effective use of an energy storage device before the start of use.

### MEANS FOR SOLVING THE PROBLEM

A data processing system according to an embodiment of the present disclosure includes a plurality of storage units each including a control device that controls charge-discharge of a plurality of energy storage devices; and a data processing device, in which
the plurality of storage units are provided at different places, each of the plurality of storage units is capable of storing a plurality of energy storage devices, the data processing device includes a memory that stores state data of the plurality of energy storage devices in association with first identification data for identifying the plurality of energy storage devices and second identification data for identifying the places, and a processor that updates the state data stored in the memory by using a state data of the plurality of energy storage devices received from the control device, and the processor derives a quality evaluation of each of the plurality of energy storage devices on the basis of the state data stored in the memory, and outputs the derived quality evaluation to the control device or another device.

### BRIEF DESCRIPTION OF DRAWINGS

Fig. 1 is a schematic diagram of a data processing system.
Fig. 2 is a schematic exploded perspective view of a storage unit.
Fig. 3 is a block diagram illustrating a configuration of the storage unit.
Fig. 4 is a block diagram illustrating a configuration of a data processing device.
Fig. 5 is a block diagram illustrating a configuration of a terminal device.
Fig. 6 is a flowchart illustrating an example of a processing procedure in a control device.
Fig. 7 is a diagram illustrating a content example of a use history table of an energy storage device included in a database.
Fig. 8 is a flowchart illustrating an example of a processing procedure in the data processing device.
Fig. 9 is a flowchart illustrating an example of a processing procedure related to a quality evaluation in the data processing device.
Fig. 10 is a diagram illustrating an example of an output screen in a quality evaluation.

### MODE FOR CARRYING OUT THE INVENTION

(1) A data processing system includes a plurality of storage units each including a control device that controls charge-discharge of an energy storage device, and a data processing device. In the data processing system, the plurality of storage units are provided at different places, and each can store a plurality of energy storage devices. The data processing device includes a memory that stores state data of the plurality of energy storage devices in association with first identification data for identifying the plurality of energy storage devices and second identification data for identifying the places, and a processor that updates the state data stored in the memory by using a state data of the plurality of energy storage devices received from the control device. The processor derives a quality evaluation of each of the plurality of energy storage devices on the basis of the state data stored in the memory, and outputs the derived quality evaluation to the control device or another device.

The energy storage device may be a lithium ion secondary battery or a lead-acid battery, but is not limited thereto, and may be another secondary battery, a primary battery, or a capacitor.

The energy storage device may be an energy storage cell or an energy storage module (hereinafter, also referred to as an assembled battery) in which a plurality of energy storage cells are connected in series and/or in parallel. The energy storage device may be an energy storage unit (hereinafter, also referred to as "bank") in which a plurality of energy storage modules are connected in series. The energy storage device may be an energy storage unit (hereinafter, also referred to as a "domain") in which a plurality of energy storage modules or banks are connected in parallel.

With respect to a used energy storage device, it is not possible to ascertain a state history (presence or absence of charge-discharge, temperature transition, and the like) of the energy storage device until transfer to another user, a manager of used energy storage devices, and the like after transfer to a user. With respect to a new energy storage device, it is possible to ascertain a state history (presence or absence of charge-discharge, temperature transition, and the like) of the energy storage device until transfer to a user after manufacture. Accordingly, it is possible to determine whether or not the new energy storage device has rapidly deteriorated from the state history thereof. Deterioration in an energy storage device may be curbed when the energy storage device is charged and discharged such that a charge rate falls within a predetermined range rather than when the energy storage device is not charged and discharged at all until the energy storage device is transferred to a user.

Conventionally, a method for effectively utilizing energy storage devices which are stored and centrally managed in a specific storage place in a uniform deterioration state is known. However, a new energy storage device is usually manufactured and then transferred to a user through storage places such as a plurality of warehouses and distribution bases. Thus, in the conventional method, there is a concern that a business operator in each storage place cannot ascertain a state history of new energy storage devices distributed in a plurality of storage places, and deterioration in the new energy storage devices cannot be curbed.

In the data processing system having the above configuration, the energy storage device is incorporated in the storage unit together with the control device in a plurality of storage places until the energy storage device is started to be used after being manufactured. Each storage unit sequentially transmits the state of the energy storage device connected to the unit to the data processing device via a communication medium. The data processing device can collect data indicating how the energy storage device is controlled to be chargeable/dischargeable in one or a plurality of storage places until the energy storage device is transferred to a user, and can guarantee a quality evaluation of each energy storage device from a charge-discharge history.

At each distribution base, an operator performs work of assembling an energy storage device that is a storage target in the storage unit including the control device, and work of detaching and carrying out the energy storage device when the storage is finished. When the operator performs such work during storage, the system supports effective use of the energy storage devices while maintaining quality of the energy storage devices by using the data processing device until the energy storage devices are transferred to users.

As an effective use method for an energy storage device, for example, charge-discharge is performed during a storage period before the energy storage device is transferred to a user. Specifically, the energy storage device may be effectively used for CO₂ reduction, demand responses using power stored in the energy storage device in the storage period, reduction in electric bill using power stored in the energy storage device for nighttime power, and the like, by using surplus power of renewable energy obtained from a photovoltaic power generating system or the like for charge-discharge of the energy storage device in the storage period.

Although a large amount of the manufactured new energy storage devices are stored in a storage place such as a warehouse, in the process of distribution, when the stored new energy storage devices are moved to a storage place such as a warehouse in each of subsequent districts, the collectively stored energy storage devices may be moved to different storage places in each district. In this case, new energy storage devices are stored not only in a large warehouse capable of storing a large amount of new energy storage devices but also in a relatively small warehouse. Since the data processing system having the above configuration can effectively use several energy storage devices connected to the storage unit, the data processing system can also be applied to a relatively small warehouse. In the present data processing system, since the new energy storage device during storage functions as a power source, the date processing system is to be available as an energy storage system by only installing the storage unit and the data processing device at the time of introduction. Compared with a conventional energy storage system which simply uses an energy storage device during the storage period without using a storage unit, the energy storage system can be introduced at low cost because the cost of the energy storage device itself at the time of introduction and the cost of maintenance and replacement of the energy storage device are not incurred. That is, in the present data processing system, the energy storage system can be easily and inexpensively introduced to a place where the energy storage system is not installed conventionally, and the effective use of the energy storage device can be promoted.

(2) In the data processing system of (1), the data processing device may output whether charge-discharge of each of the plurality of energy storage devices stored in each storage unit can be performed to the control device of each storage unit on the basis of the quality evaluation.

With such a configuration, the data processing system can effectively use the energy storage device by performing charge-discharge during a storage period until the energy storage device is transferred to a user, and can control an appropriate degree of use for maintaining quality. The data processing system quickly finds a defective product (for example, a defective product in which a lead-acid battery has overturned at the time of shipment and liquid leakage has occurred) generated during a storage period until the energy storage device is transferred to a user and helps a storage manager or the like immediately arrange a substitute energy storage device, and improving reliability of the user and a vendor is expected. Since the storage place until the energy storage device is transferred to a user can be ascertained by an administrator of the data processing system, the administrator can specify at which stage the defective product has occurred, and the administrator can easily take measures to reduce a defect ratio at the time of transferring the energy storage device to a vendor or a user.

(3) In the data processing system of (2), the control device may transmit power from a dischargeable energy storage device to a power network to which the storage unit having the energy storage device is connected.

With such a configuration, the data processing system can effectively use the energy storage device by performing charge-discharge during a storage period until the energy storage device is transferred to a user.

(4) In the data processing system according to any one of (1) to (3), the storage unit may include a connection box provided with a plurality of connection terminals respectively detachably attached to terminals of arrayed plurality of energy storage devices, and the connection box may include a connection portion with the control device.

With the above configuration, it is possible to effectively use the energy storage devices temporarily stored in various places through easy work of connecting the plurality of energy storage devices by covering the plurality of energy storage devices with the connection box.

(5) A connection box includes a plate-shaped member that covers a plurality of energy storage devices each having a rectangular parallelepiped outer shape in a case where the plurality of energy storage devices are arrayed, in which a plurality of connection terminals respectively detachably attached to terminals of arrayed plurality of energy storage devices are provided on one surface of the plate-shaped member, and the plurality of connection terminals are connected to each other to connect the plurality of energy storage devices in series.

With the above configuration, it is possible to effectively use the energy storage devices temporarily stored in various places through easy work of connecting the plurality of energy storage devices by covering the plurality of energy storage devices with the connection box.

(6) A data processing method includes: by a data processing device capable of transmitting and receiving data to and from a plurality of control devices via a communication medium with respect to a plurality of storage units including the control devices that control charge-discharge of a plurality of energy storage devices, storing state data of the plurality of energy storage devices in association with first identification data for identifying the plurality of energy storage devices and second identification data for identifying a storage place where the plurality of energy storage devices is stored, updating the state data stored by using a state data of the plurality of energy storage devices received from the control devices, sequentially deriving a quality evaluation of each of the plurality of energy storage devices on the basis of the stored state data, and outputting the derived quality evaluation to the control devices or another device.

The present invention will be specifically described with reference to the drawings illustrating embodiments thereof.

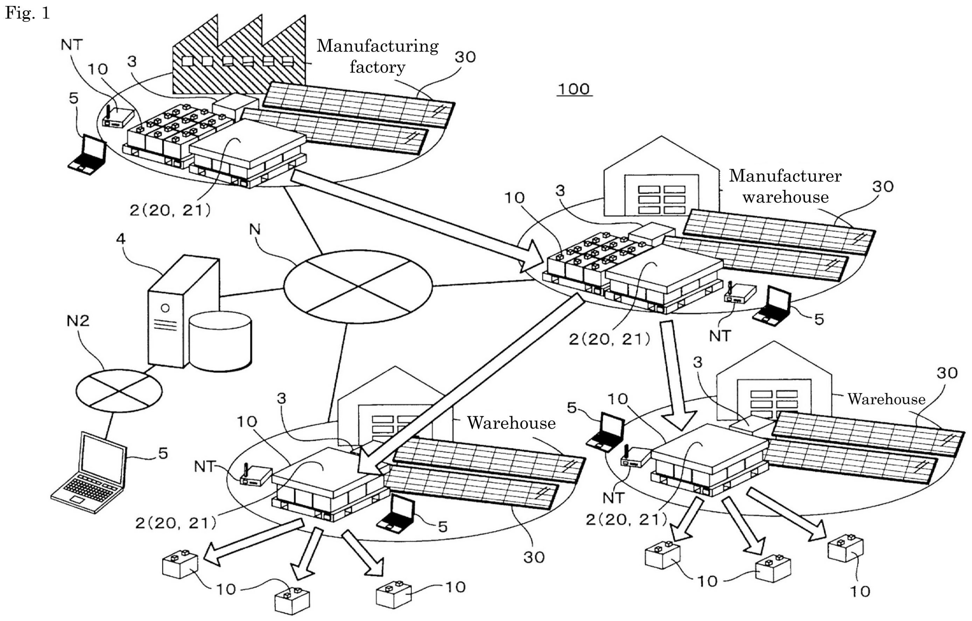

Fig. 1 is a schematic diagram of a data processing system 100. The data processing system 100 includes storage units 2 installed in a plurality of storage places of energy storage devices 10, a power supply device 3 connected to the storage unit 2 at each place, and a data processing device 4 that processes data from the storage unit 2 at each place. The data processing system 100 includes a network N which is a communication medium that communicatively connects the storage unit 2 installed in each place and the data processing device 4. The terminal device 5 can be communicatively connected to the data processing device 4 via the network N or another network N2. The network N includes local area networks at various places (not illustrated).

The place where the storage unit 2 is installed is, for example, a manufacturing factory of the energy storage device 10, a warehouse owned by a manufacturer, or a warehouse of the energy storage device 10 in each district. The warehouse owned by the manufacturer and the warehouse in each district may be different in business operator, or may be the same in business operator. The energy storage device 10 is manufactured in the manufacturing factory, temporarily stored, then transported to the warehouse of the manufacturer, and stored in the warehouse in each district as an inventory of a vendor of the energy storage device 10 in each district. The vendor may be, for example, a dealer of the energy storage device 10 or a car dealer. The data processing system 100 effectively uses the energy storage device 10 stored in each place in cooperation with a power generating system 30 in each place and guarantees the quality of the used energy storage device 10 during a period until the energy storage device 10 is delivered to a user from the warehouse in each district via the warehouse of the manufacturer after the energy storage device 10 is manufactured in the manufacturing factory.

The storage unit 2 includes a connection box 21 to which a plurality of energy storage devices 10 arrayed in a storage place is detachably attached, and a control device 20 that acquires state data of the connected energy storage devices 10. The storage unit 2 is installed at each place. The storage unit 2 of the manufacturing factory remains installed in the manufacturing factory, but the connected energy storage device 10 is detached from the connection box 21 at the timing of being moved from the manufacturing factory to the warehouse of the manufacturer, and is connected to the connection box 21 of the storage unit 2 installed in the next warehouse. In a case where the energy storage device 10 connected to the connection box 21 disposed in the warehouse of the manufacturer is moved to the warehouse in each of subsequent districts, the energy storage device 10 is detached from the connection box 21 and connected to the connection box 21 installed in the next warehouse. As described above, the energy storage device 10 is connected to the connection box 21 every time the energy storage device 10 is distributed to the plurality of distribution bases. When the plurality of energy storage devices 10 is moved to the warehouse in each of the subsequent districts, the plurality of energy storage devices 10 may be divided, and the plurality of divided energy storage devices 10 may be moved to different warehouses in each district. In this operation method, the inventory of the energy storage devices 10 can be moved and used not only in a large warehouse capable of storing a large inventory of the energy storage devices 10 but also in a relatively small warehouse. As a result, the number of warehouses that store a small inventory of the energy storage devices 10 increases. Further, since the storage unit 2 can be operated even when a small amount of energy storage devices 10 are connected, it is easy to install the storage unit 2 even in a place where an energy storage system is not installed in the related art.

The connection box 21 has contacts in advance to connect the plurality of connected energy storage devices 10 in series. The connection box 21 is connected to a power supply device (power conditioner) 3 disposed at each place. The control device 20 and the power supply device 3 are connected so as to be able to exchange signals. The power supply device 3 charges and discharges the energy storage devices 10 connected in series attached to the connection box 21. As illustrated in Fig. 1, the power supply device 3 uses the power generating system 30 and the energy storage device 10 in cooperation with each other. The power supply device 3 may be connected to system power. Details of the connection box 21 will be described later.

The control device 20 transmits the acquired state data of the energy storage device 10 and the charge-discharge history by the power supply device 3 to the data processing device 4 via the network N. The state data includes a charge rate and a voltage value of each energy storage device 10. The state data may include a current value, a temperature, and an internal resistance value. The state data may include any one of a charge rate, a voltage value, a current value, a temperature, and an internal resistance value of the whole of the plurality of energy storage devices 10 connected in series.

The data processing device 4 receives the state data and the charge-discharge history transmitted from the control device 20 of the storage unit 2 at each place. The data processing device 4 stores the number of times the energy storage devices 10 are used for charge-discharge and transition of the charge rate of the energy storage devices 10 until each energy storage device is detached from the storage unit 2 in the warehouse in each district from the manufacturing factory. When the energy storage device 10 is transferred from the warehouse in each district to a user, data indicating a history of the energy storage device 10 can be output. An output destination may be each control device 20 or a terminal device 5 that can be connected to a local area network of each place via a wireless communication device NT or a wire (not illustrated) and is used in each place.

With such a configuration, the data processing system 100 can realize effective use of each energy storage device 10 during a period from manufacture to transfer of the energy storage device 10 to a user, and can guarantee that the energy storage device 10 does not deteriorate at a point of time of the transfer to the user. In order to prevent the charge-discharge from being excessive while it takes time to transfer the energy storage device 10 to a user, the data processing device 4 can also provide a notification for giving an instruction for curbing of the charge-discharge or detachment of the energy storage device.

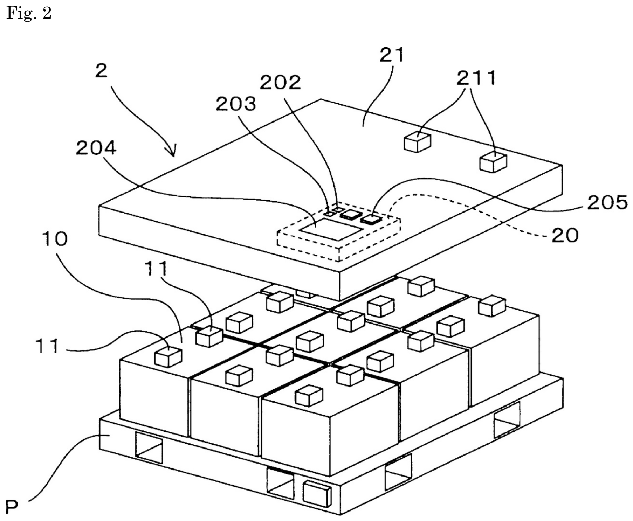

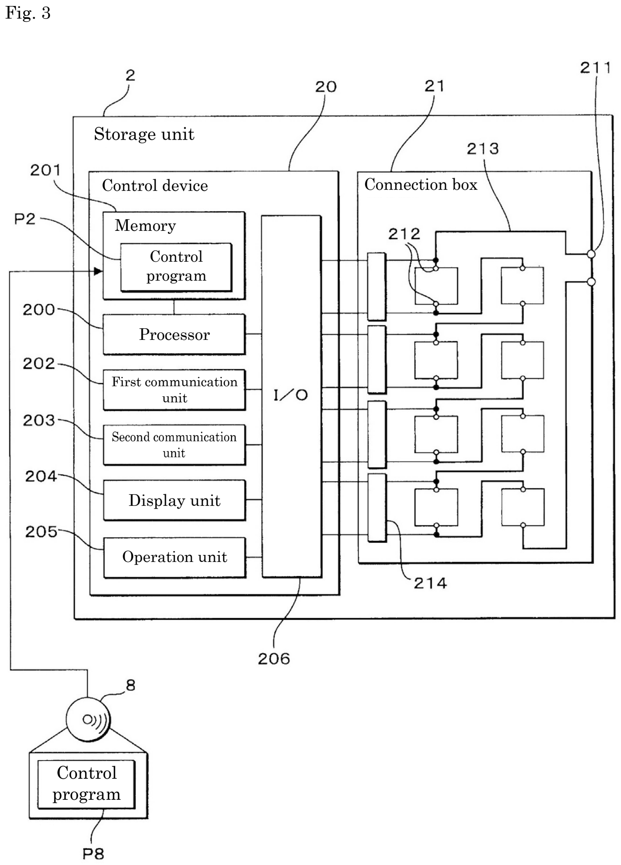

Details of the data processing system 100 will be described below. Fig. 2 is a schematic exploded perspective view of the storage unit 2. The storage unit 2 uses a connection box 21 in which a side wall is provided on a plate-shaped member covering the plurality of energy storage devices 10 which are lead-acid batteries arrayed on a pallet P. Terminals (contacts) 212 (see Fig. 3) to which terminals 11 of the respective energy storage devices 10 are detachably attached are provided on an inner surface of the connection box 21. The plurality of terminals 212 to which the terminals 11 of the respective energy storage devices 10 are detachably attached are connected to each other as illustrated in Fig. 3, and the plurality of energy storage devices 10 are formed to be connected in series when the connection box 21 covers the plurality of energy storage devices 10. Electrodes 211 connected to the terminals 11 of the plurality of energy storage devices 10 via the contacts formed on the inner side are provided on an outer side of the connection box 21. The electrodes 211 are connected to the power supply device 3 which is a power conditioner, and charge-discharge by the power conditioner can be performed. In the case of a lead-acid battery, the terminal 11 of the energy storage device 10 is a positive electrode terminal or a negative electrode terminal of a lead-acid battery for starting according to JIS D5301:2019.

The control device 20 is attached to the connection box 21. The control device 20 is a control board, and an interface (first communication unit) 202 of a communication circuit included in the control device 20, a communication interface (second communication unit) 203 for the power supply device 3, a display (display unit) 204, and a button (operation unit) 205 are exposed.

The energy storage device 10 is not limited to a lead-acid battery, and an aspect of connection between the energy storage devices 10 is not limited to series connection. The connection box 21 may support the energy storage device 10 from below like the pallet P. In a case where the energy storage device 10 is a lithium energy storage module (assembled battery), the connection box 21 may be configured to cover the energy storage devices 10 stored in a vertically accommodated manner on a shelf called an energy storage board from a back surface (front surface).

An operator at each storage place performs work of covering the energy storage devices 10 arrayed on the pallet P or the energy storage devices 10 individually carried in and arrayed on the pallet P with the connection box 21. The operator connects the electrodes 211 of the connection box 21 to the power supply device 3, and connects the power supply device 3 to the communication interface 203 via a communication cable. The operator connects a communication connection cable or a wireless communication module with the local area network of the storage place to the interface 202 of the communication circuit. The operator may input identification data (first identification data) of the energy storage device 10 covered with the connection box 21 by using the display 204 of the control device 20 and the operation unit 205. The operator operates the operation unit 205 of the control device 20 (for example, "start") to start charge-discharge from the power supply device 3. When carrying out the energy storage device 10, the operator in each storage place may perform the above-described work in reverse.

Fig. 3 is a block diagram illustrating a configuration of the storage unit 2. The storage unit 2 includes the control device 20 and the connection box 21. The control device 20 includes a processor 200, a memory 201, a first communication unit 202, a second communication unit 203, a display unit 204, an operation unit 205, and an I/O 206.

The processor 200 is a processor using a central processing unit (CPU) and/or a graphics processing unit (GPU). The processor 200 executes a process of transmitting state data and a charge-discharge history of the energy storage device 10 and receiving data transmitted from the data processing device 4 on the basis of a control program P2 stored in the memory 201.

The memory 201 uses a non-volatile memory such as a flash memory or a solid state drive (SSD). The memory 201 stores the control program P2 and data referred to by the processor 200. The control program P2 may be obtained by the processor 200 reading a control program P8 stored in a storage medium 8 and copying the control program P8 to the memory 201. The control program P2 may be downloaded from a program server device (not illustrated) via the first communication unit 202 and stored in an executable manner.

The first communication unit 202 performs communication with the data processing device 4 via the network N. Specifically, first communication unit 202 is a network card for connection to a local area network (LAN) of each storage place. The first communication unit 202 may be a wireless communication device for WiFi. The first communication unit 202 may be a communication interface compatible with the ECHONET (registered trademark)/ECHONETLite (registered trademark) standard, or may be a controller area network (CAN) interface. The processor 200 can transmit and receive data to and from the data processing device 4 via the first communication unit 202.

In a case where the connection from the local area network of the storage place managed by each of different business operators to the network N becomes a security problem, the first communication unit 202 may be a communication device that communicates with the network N via carrier communication, or may be a communication device that can be directly communicatively connected to the network N that is a dedicated line. The first communication unit 202 may be replaced with a communication unit of a maintenance terminal device of a manufacturer, and data may be transmitted to the data processing device 4 via the maintenance terminal device.

The second communication unit 203 is a communication interface with the power supply device 3. The second communication unit 203 is, for example, a serial communication interface conforming to RS232C or RS485. For example, the power supply device 3 includes a control unit having a serial communication function conforming to RS485, and the second communication unit 203 communicates with the control unit.

The display unit 204 is a display such as a liquid crystal display, a segment display, or an organic electro luminescence (EL) display, an LED lamp, or the like. The operation unit 205 uses a physical button, a switch, a dial, or the like. The processor 200 recognizes an operation on the operation unit 205, and outputs, to the display unit 204, text, an image, light, and the like indicating operation content, a driving status, or data of the energy storage device 10. The display unit 204 is, for example, a touch panel built-in type display, and may be integrated with the operation unit 205. The display unit 204 may be provided together with a sound output unit, and the processor 200 may output a sound effect, a warning sound, or the like and notify the display.

The I/O 206 is an input/output interface of the processor 200. In Fig. 3, the processor 200 is connected to the first communication unit 202, the second communication unit 203, the display unit 204, and the operation unit 205 via the I/O 206, but the present invention is not limited thereto. The I/O 206 is connected to a measurement unit (for example, cell monitoring unit (CMU))214 for each energy storage device 10 connected to the connection box 21. The processor 200 can acquire the state data of each energy storage device 10 connected to the connection box 21 from the measurement unit 214 via the I/O 206.

The connection box 21 is provided with terminals 212 detachably attached to the terminals of the energy storage device 10. In the connection terminals 212, a wiring 213 is disposed to connect the attached energy storage devices 10 in series. Both ends of the wiring 213 connecting the energy storage devices 10 in series are connected to the electrodes 211. An aspect of the wiring 213 is not limited to the aspect illustrated in Fig. 3. Even if only one energy storage device 10 is attached, the wiring 213 may be connected to the electrodes 211.

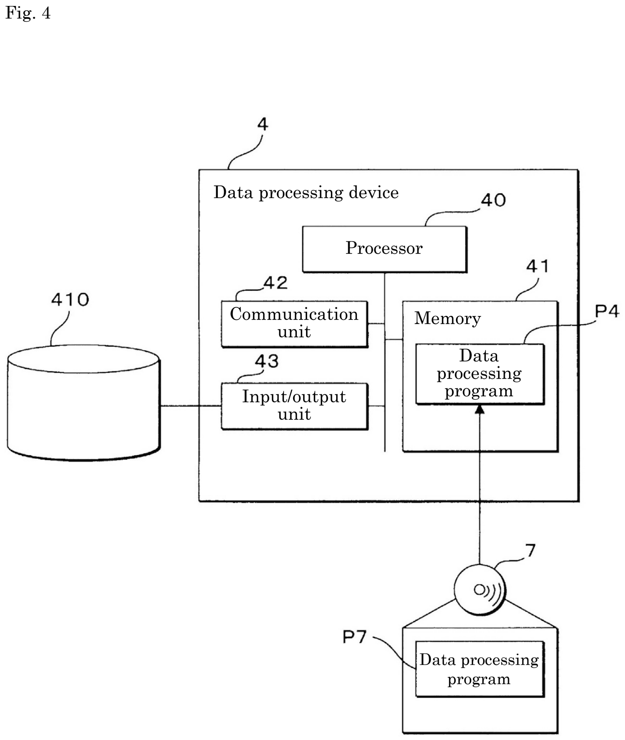

Fig. 4 is a block diagram illustrating a configuration of the data processing device 4. The data processing device 4 is a server computer. The data processing device 4 will be described below as one server computer for ease of description, but may have a configuration in which processes or functions are distributed to a plurality of server computers communicatively connected to each other.

The data processing device 4 includes a processor 40, a memory 41, a communication unit 42, and an input/output unit 43. The processor 40 is a processor using a CPU or a GPU. The processor 40 controls each constituent by using built-in RAM and ROM. The processor 40 executes information processing that will be described later on the basis of a data processing program P4 stored in the memory 41.

The memory 41 uses a hard disk or an SSD. The memory 41 stores the data processing program P4 and also stores other programs and data to be referred to by the processor 40. The data processing device 4 constructs a database 410 in a recording device provided inside or outside the memory 41. The data processing program P4 stored in the memory 41 may be a program in which a data processing program P7 stored in a computer-readable storage medium 7 is read by the processor 40 and stored in the memory 41, or may be downloaded from a program distribution server.

The communication unit 42 performs communication via the network N or the network N2. The processor 40 can transmit and receive data to and from the control device 20 of the storage unit 2 at each place via the network N which is a local area network or a dedicated line by using the communication unit 42. The processor 40 can transmit and receive data to and from the terminal device 5 by using the communication unit 42 via the network N2, and via the network N2 and a public communication network depending on cases.

The input/output unit 43 is a connection interface with a storage device storing the database 410. This is unnecessary when the database 410 is provided in the memory 41.

The processing procedure in the data processing device 4 configured as described above will be described in detail later.

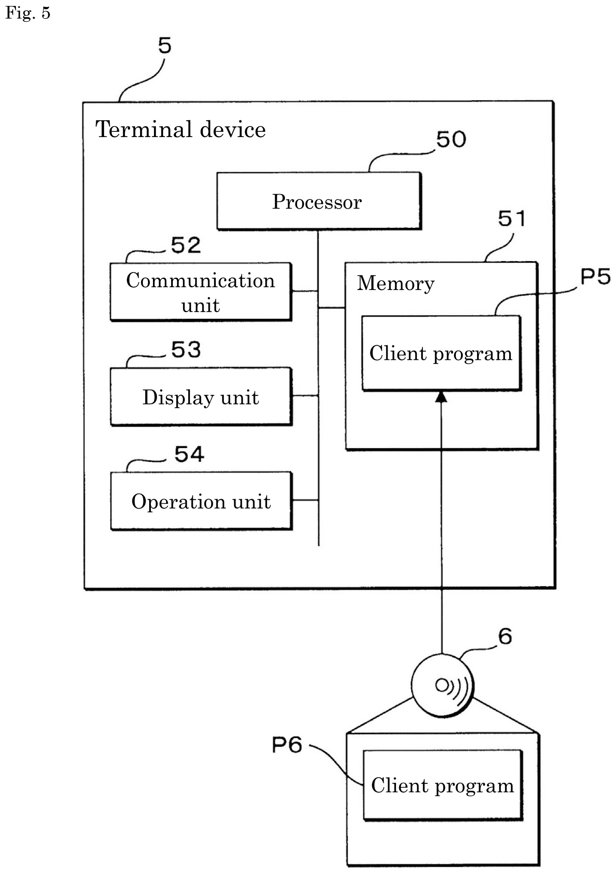

Fig. 5 is a block diagram illustrating a configuration of the terminal device 5. The terminal device 5 is a laptop or tablet personal computer. The terminal device 5 may be a smartphone or a desktop personal computer.

The terminal device 5 includes a processor 50, a memory 51, a communication unit 52, a display unit 53, and an operation unit 54.

The processor 50 includes a processor using a CPU or a GPU, and controls each constituent by using built-in RAM and ROM. The processor 50 may read a client program P5 stored in the memory 51, acquire a web page or the like indicating information regarding a state or quality assurance of each energy storage device 10 provided by the data processing device 4, and display the acquired web page or the like on the display unit 53.

The memory 51 uses a flash memory or an SSD. In addition to storing the client program P5, the memory 51 may store account data of a user, other data referred to by the processor 50, and the like.

The communication unit 52 is a communication device that performs communication via the network N, the network N2, or a public communication network. The communication unit 52 may be a wired communication device or a wireless communication device.

The display unit 53 uses a display device such as a liquid crystal panel or an organic EL display. The operation unit 54 is an interface that receives an operation. The operation unit 54 uses a physical button, a keyboard, a pointing device, a touch panel device built into the display unit 53, a speaker, a microphone, and the like. The operation unit 54 may receive an operation on a screen displayed on the display unit 53 via a physical button or a touch panel, or may recognize operation content from an input voice by using a microphone and receive an operation in an interactive form with a voice output from a speaker.

A process in the data processing system 100 configured as described above will be described below. When the energy storage device 10 is manufactured in the manufacturing factory, a serial code (first identification data) is assigned to each energy storage device 10. The serial code may be printed on a housing of each energy storage device 10 or a seal may be attached thereto. When a control board (CMU) is built into the energy storage device 10, the serial code is stored in the control board. Each time the serial code is issued by a production management system of the manufacturer, the serial code is made into a database and can be referred to from the data processing device 4. The serial code is information for identifying the energy storage device 10. The serial code differs for each energy storage device 10, and may include information unique to an individual and a source of the energy storage device 10. For example, the serial code includes a plurality of character strings and numerical strings. For example, the serial code may be a model number for identifying a model of the energy storage device 10, a lot number for identifying a production lot of the energy storage device 10, a number for identifying a production date of the energy storage device 10, or an individual identification number for identifying each energy storage device 10. Even when the model numbers for identifying the models of the plurality of energy storage devices 10 are identical, the plurality of energy storage devices 10 can be identified for each lot number if the lot numbers are different from each other. Even if the lot numbers of the plurality of energy storage devices 10 are identical, the plurality of energy storage devices 10 can be identified for each production date if the numbers for identifying the production dates are different. Even if the numbers for identifying the production dates of the plurality of energy storage devices 10 are identical, the plurality of energy storage devices 10 can be identified for each individual identification number if the individual identification numbers are different. On the basis of the serial code, sources of the respective energy storage devices 10 and the energy storage devices 10 can be identified one by one. In a case where the serial code is an individual identification number, even if the lot numbers or the numbers for identifying the production dates of the plurality of energy storage devices 10 are identical, the serial codes are different from each other, and it is possible to reliably identify each energy storage device 10, which is preferable. Furthermore, the serial code may be a code such as a two-dimensional code displayed in a figure.

Identification data (second identification data) is assigned in advance to each of the storage units 2 present in the storage places. The memory 201 of the control device 20 stores identification data (second identification data) of the storage place (storage unit 2). The identification data (second identification data) may be, for example, an identification code allocated for each storage place of the storage unit 2 or the name of the storage place. The processor 200 of the control device 20 automatically acquires the serial code of the energy storage device 10 from the measurement unit 214 of the connection box 21 or receives input thereof from the operation unit 205. The control device 20 may include a reading unit such as a camera, a scanner, and a reader, and acquire the serial code by reading characters, barcodes, two-dimensional codes, and the like printed on the outer surface of the energy storage device 10. The data processing device 4 stores identification data (second identification data) of each storage unit 2 in the database 410. The data processing device 4 may store identification data of a business operator managing the storage unit 2, a contact address of the business operator, the name of the storage place of the storage unit 2, an address of the storage place, and the like in association with the identification data (second identification data) of the storage unit 2.

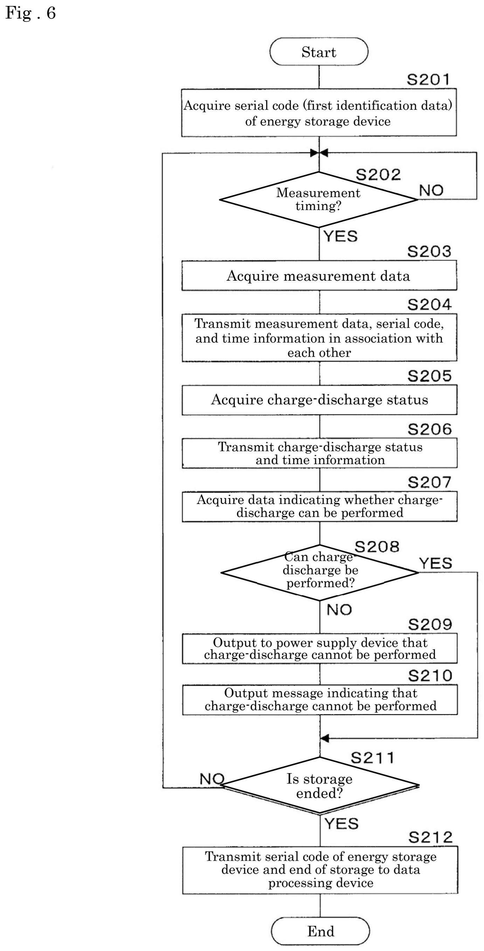

Fig. 6 is a flowchart illustrating an example of a processing procedure in the control device 20. When activated through the supply of power, the processor 200 of the control device 20 executes the following processes.

Upon activation, the processor 200 acquires a serial code (first identification data) of the energy storage device 10 connected to the connection terminals 212 of the connection box 21 (step S201).

The processor 200 determines whether a measurement timing has arrived (step S202), and in a case where it is determined that the measurement timing has not arrived (S202: NO), the process returns to step S202. In step S202, the processor 200 stores the measurement timing in the memory 201 so that the measurement timing arrives periodically (for example, once a day or once a few seconds). In step S202, the processor 200 may determine that the measurement timing has arrived when there is a measurement request from the data processing device 1.

In a case where it is determined that the measurement timing has arrived (S202: YES), the processor 200 acquires measurement data of each energy storage device 10 from the measurement unit 214 (step S203). The acquired measurement data includes a voltage value of each energy storage device 10. The measurement data may be a charge rate, a current value, a temperature, or an internal resistance value of the energy storage device 10.

The processor 200 transmits the acquired measurement data of each energy storage device 10 from the first communication unit 202 to the data processing device 4 in association with the serial code of the energy storage device 10 and time information of the measurement timing (step S204).

The processor 200 acquires data indicating a charge-discharge status (during charge, during discharge, during stop) of the energy storage device 10 connected to the connection box 21 from the power supply device 3 via the second communication unit 203 (step S205). The processor 200 transmits the identification data (second identification data) of the storage unit 2, the serial code of the energy storage device 10, the acquired charge-discharge status, and the acquired time information of the timing in association with one another from the first communication unit 202 to the data processing device 4 (step S206).

The processor 200 acquires data indicating whether charge-discharge of each energy storage device 10 can be performed from the data processing device 4 (step S207). The processor 200 determines whether charge-discharge of all the energy storage devices 10 connected to the connection box 21 can be performed (step S208). In a case where it is determined that charge-discharge of all the energy storage devices 10 connected to the connection box 21 can be performed (S208: YES), the processor 200 causes the process to proceed to step S210.

In a case where it is determined that charge-discharge of some of the energy storage device 10 connected to the connection box 21 cannot be performed (S208: NO), the processor 200 outputs, to the power supply device 3 via the second communication unit 203, that charge-discharge cannot be performed (step 209).

The processor 200 may display a message, a warning image, an alarm, and the like indicating that charge-discharge cannot be performed on the display unit 204, and output an alarm by sound (step S210).

The processor 200 determines whether the storage of the connected energy storage device 10 is ended (step S211). In step S211, in a case where the end button is pressed on the operation unit 205, the processor 200 can presume that it is intended to turn off the power supply of the storage unit 2 in order to take out the energy storage device 10 from the connection box 21.

In a case where it is determined that the storage is not ended (S211: NO), processor 200 returns the process to step S202. In a case where it is determined that the storage is ended (S211: YES), the processor 200 transmits the end of the storage of the connected energy storage device 10 to the data processing device 4 together with the serial code of each energy storage device 10 (step S212). Thereafter, the processor 200 automatically transitions to the power-off state.

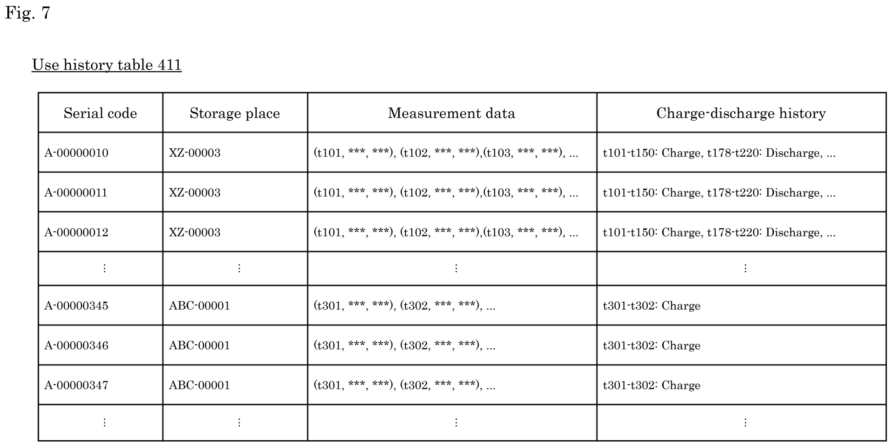

Each time the data processing device 4 receives data from the control device 20 of the storage unit 2, the data processing device 4 updates a table of the use history of each energy storage device 10 stored in the database 410 by using the measurement data and the data indicating the charge-discharge status. Fig. 7 is a diagram illustrating a content example of a use history table 411 of the energy storage device 10 included in the database 410.

The use history table 411 illustrated in Fig. 7 stores, as a storage place, identification data (second identification data) of the storage unit 2 to which the energy storage device 10 is connected at that time in association with a serial code of the energy storage device 10. Each time the data processing device 4 receives measurement data for each energy storage device 10, the use history table 411 stores and updates an identification code of the storage unit 2 (storage place) to which the energy storage device 10 is connected. In the example illustrated in Fig. 7, the energy storage device 10 having the identification code "A-00000010" is connected to the storage unit 2 in the warehouse in the district having the identification code "XZ-00003". The energy storage device 10 having the identification code "A-00000345" is connected to the storage unit 2 of the manufacturing factory having the identification code "ABC-00001". The use history table 411 may store the transition of the storage place as a data string of the identification code. For example, the use history table 411 may store transitions of storage places of the energy storage device 10 having the identification code "A-00000010" as "ABC-00001, ABC-30001, and XZ-00003".

The use history table 411 stores the received measurement data in association with the serial code of the energy storage device 10 every time the data processing device 4 receives the measurement data for each energy storage device 10. In the use history table 411 illustrated in Fig. 7, a history of measurement data obtained from the control device 20 of the storage unit 2 at each place for the energy storage device 10 having the identification code "A-00000010" is stored in association with time information after "t101".

Each time the data processing device 4 receives data indicating a charge-discharge status from the control device 20 of each storage unit 2, the use history table 411 stores the status in association with a record of the serial code of the energy storage device 10 connected to the storage unit 2. In the example in Fig. 7, a charge-discharge history of the energy storage device 10 having the identification code "A-00000010" indicates that the energy storage device 10 was charged at "t101" to "t150" and was discharged at "t178" to "t220".

In the example in Fig. 7, the time information "t101", "t150", "t178", "t220", ... indicates a later time as the number increases, and may be a numerical value or text corresponding to a time point or count data.

In the example in Fig. 7, similarly, a history of measurement data obtained from the control device 20 of the storage unit 2 at each place for the energy storage device 10 having the identification code "A-00000345" is stored in association with time information after "t301". In the example in Fig. 7, the energy storage device 10 having the identification code "A-00000345" is shorter in the number of elapsed days from the manufacture than the energy storage device 10 having the identification code "A-00000010", and the charge has just been started.

As described above, the use history of the energy storage device 10 is stored in the database 410 on the basis of the state data and the charge-discharge status of each energy storage device 10 acquired from the control device 20. An aspect of storing the state data of each energy storage device 10 stored in the database 410 is not limited to the use history table 411 illustrated in Fig. 7. The database 410 may store a table storing only the most recently received state data and a history table separately, or may store a charge-discharge status of each storage unit 2 as a time table.

In a case where each energy storage device 10 is finally transferred to a user, the data processing device 4 is notified that the energy storage device 10 has been sold by the vendor. The record of the energy storage device 10 in the database 410 is separately stored in a soldenergy storage device database, and the energy storage device 10 is not subjected to the update process and the following processes.

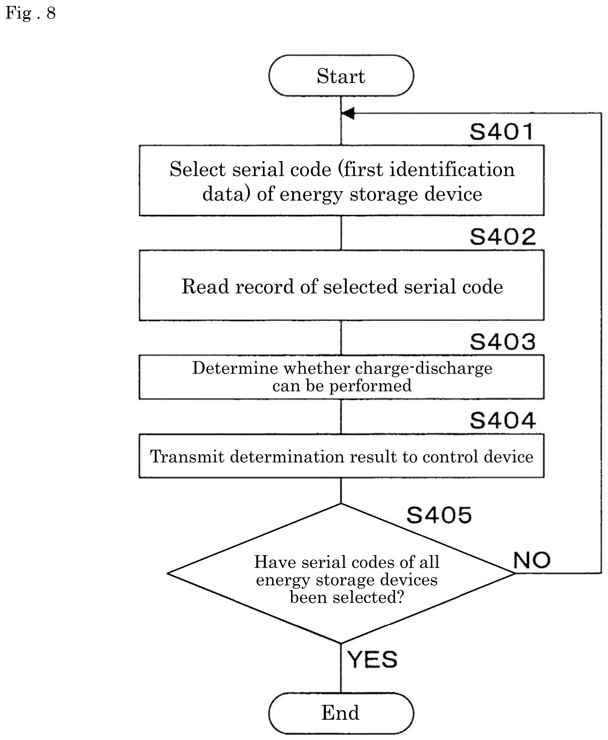

The data processing device 4 sequentially executes the following processes in parallel with update of the database 410. Fig. 8 is a flowchart illustrating an example of a processing procedure in the data processing device 4.

The processor 40 of the data processing device 4 selects the serial codes (first identification data) of the energy storage devices 10 one by one (step S401). The processor 40 reads a record of the use history table 411 by using the selected serial code (step S402).

The processor 40 determines whether subsequent charge-discharge can be performed on the basis of the charge-discharge history included in the read record and the history of the measurement data (step S403). In step S403, the processor 40 determines that charge cannot be performed when the charge-discharge time (used time) of the energy storage device 10 is a predetermined time or more and the charge rate is sufficiently high, and determines that charge can be performed otherwise. The processor 40 may make a determination based on the cycle number, only the charge-discharge time (the used time), or only the charge rate.

The processor 40 designates the serial code of the target energy storage device 10 and transmits the determination result to the control device 20 (step S404). In a case where the determination result indicates that charge-discharge cannot be performed, it is determined that charge-discharge cannot be performed in step S208 of the flowchart in Fig. 6, and charge-discharge is stopped by the power supply device 3.

The processor 40 determines whether the serial codes of all the energy storage devices 10 have been selected (step S405). In a case where the processor 40 determines that there is a serial code that has not been selected (S405: NO), the process returns to step S401 such that a serial code of the next energy storage device 10 is selected.

In a case where it is determined that the serial codes of all the energy storage devices 10 have been selected in step S405 (S405: YES), the processor 40 ends the process.

Since the use history of each energy storage device 10 is stored in the database 410, the evaluation of the quality of the energy storage device 10 can be provided to a user or a vendor at the time of transfer (sale) to the user. The evaluation of the quality may be given by a CO₂ reduction amount or a power saving amount derived from the use history.

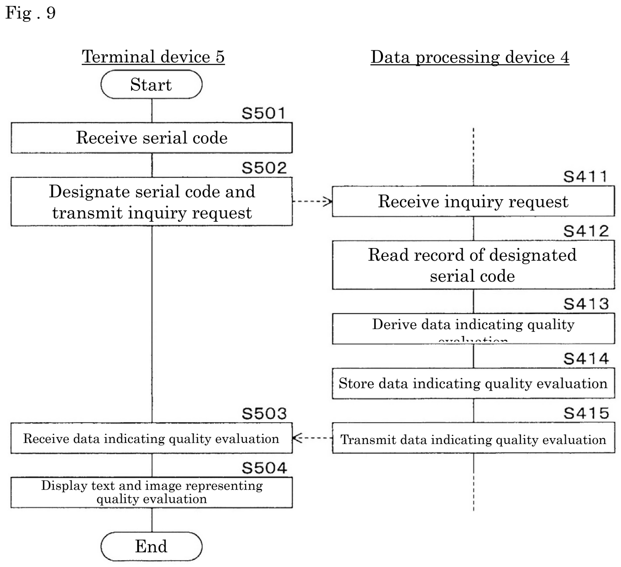

Fig. 9 is a flowchart illustrating an example of a processing procedure related to a quality evaluation in the data processing device 4. Hereinafter, the data processing device 4 executes a process of returning the quality evaluation to the terminal device 5 on the basis of an inquiry from the terminal device 5. The following process may be executed on the basis of an inquiry from the control device 20.

The processor 50 of the terminal device 5 receives the serial code of the energy storage device 10 that is an inquiry target when an operation is performed on the operation unit 54 (step S501). The processor 50 designates the received serial code and transmits an inquiry request to the data processing device 4 (step S502).

Upon receiving the inquiry request (step S411), the processor 40 of the data processing device 4 reads a record of the serial code designated by the inquiry request from the database 410 (step S412). The record read in step S412 includes the record of the use history table 411 illustrated in Fig. 7.

The processor 40 derives data indicating the quality evaluation of the target energy storage device 10 according to a predetermined algorithm on the basis of the charge-discharge history included in the read record and the history of the measurement data (step S413). In step S413, for example, in a case where the charge-discharge time (used time) of the energy storage device 10 is within a predetermined time and the charge rate is sufficiently high, the processor 40 derives the quality evaluation as the highest "A" among three levels (for example, A/B/C). In addition, in step S413, the processor 40 may derive the quality evaluation as a numerical value (out of 100 points) depending on whether the transition of the charge rate falls within a predetermined range. For example, the processor 40 may derive "100 points" in a case where a state in which the charge rate of the energy storage device is 40% to 80% is 50% or more of the period from the time of manufacture to that time, and may derive "90 points" in a case where the state is 30% to 50%. What kind of quality evaluation is performed under what kind of charge-discharge condition may be designed by using a known method depending on the type of storage battery.

The processor 40 stores data indicating the derived quality evaluation in the database 410 in association with the serial code of the energy storage device 10 (step S414).

The processor 40 transmits data indicating the derived quality evaluation to the terminal device 5 that is an inquiry source (step S415). The data processing device 4 may execute the processes from step S411 to step S415 each time an inquiry is made. The processor 40 may execute the processes from step S412 to step S414 each time the state data of each energy storage device 10 is updated, and transmit the data indicating the quality evaluation stored in response to the inquiry.

The processor 50 of the terminal device 5 receives the data indicating the quality evaluation (step S503), displays text, an image, and the like indicating the received quality evaluation on the display unit 53 (step S504), and ends the process.

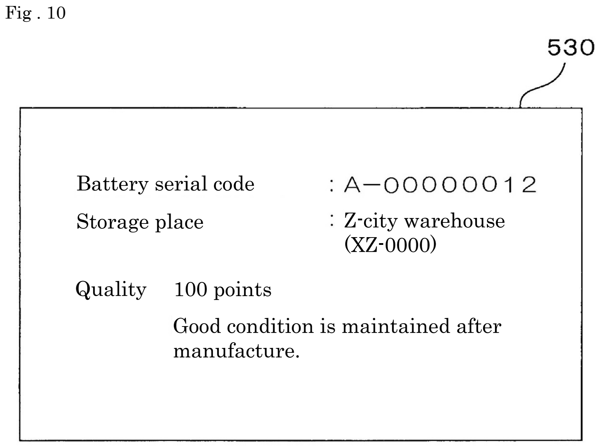

Fig. 10 is a diagram illustrating an example of a quality evaluation output screen 530. The example in Fig. 10 is displayed on the display unit 53 of the terminal device 5. In Fig. 10, the output screen 530 includes text indicating a serial code of the energy storage device 10 that is an inquiry target and a storage place of the energy storage device 10. The output screen 530 includes text indicating the score "100 points" corresponding to the quality evaluation.

A vendor or a user who visually recognizes the output screen 530 as illustrated in Fig. 10 can ascertain that the quality of the energy storage device 10 used for charge-discharge at each storage place before being transferred to the user is good, and rather, the risk of deterioration is lower than that in a case where the energy storage device 10 is not used at all after being manufactured.

As described above, by using the storage unit 2 in each place, it is possible to effectively use the energy storage device 10 in the storage place in a state in which deterioration is not unnecessarily promoted while managing the use history in the data processing device 4.

The embodiments disclosed as described above are illustrative in all respects and are not limited. The scope of the present invention is defined by the claims, and includes meanings equivalent to the claims and all modifications within the scope.

### DESCRIPTION OF REFERENCE SIGNS

100: Data processing system
10: Energy storage device
2: Storage unit
20: Control device
202: First communication unit
203: Second communication unit
204: Display unit
21: Connection box
30: Power generating system
4: Data processing device
40: Processor
41: Memory
410: Database
42: Communication unit
5: Terminal device
53: Display unit

## Claims

1. A data processing system comprising:
a plurality of storage units each including a control device that controls charge-discharge of a plurality of energy storage devices; and
a data processing device,
wherein the plurality of storage units are provided at different places,
each of the plurality of storage units is capable of storing a plurality of energy storage devices,
the data processing device includes
a memory that stores state data of the plurality of energy storage devices in association with first identification data for identifying the plurality of energy storage devices and second identification data for identifying the places, and
a processor that updates the state data stored in the memory by using a state data of the plurality of energy storage devices received from the control device, and
the processor
derives a quality evaluation of each of the plurality of energy storage devices on the basis of the state data stored in the memory, and
outputs the derived quality evaluation to the control device or another device.

2. The data processing system according to claim 1, wherein the data processing device outputs whether charge-discharge of each of the plurality of energy storage devices stored in each storage unit is able to be performed to the control device of each storage unit on the basis of the quality evaluation.

3. The data processing system according to claim 2, wherein the control device transmits power from a dischargeable energy storage device to a power network to which the storage unit having the energy storage device is connected.

4. The data processing system according to any one of claims 1 to 3, wherein
the storage unit includes a connection box provided with a plurality of connection terminals respectively detachably attached to terminals of arrayed plurality of energy storage devices, and
the connection box includes a connection portion with the control device.

5. A connection box comprising:
a plate-shaped member that covers a plurality of energy storage devices each having a rectangular parallelepiped outer shape in a case where the plurality of energy storage devices are arrayed,
wherein a plurality of connection terminals respectively detachably attached to terminals of arrayed plurality of energy storage devices are provided on one surface of the plate-shaped member, and
the plurality of connection terminals are connected to each other to connect the plurality of energy storage devices in series.

6. A data processing method comprising:
by a data processing device capable of transmitting and receiving data to and from a plurality of control devices via a communication medium with respect to a plurality of storage units including the control devices that control charge-discharge of a plurality of energy storage devices,
storing state data of the plurality of energy storage devices in association with first identification data for identifying the plurality of energy storage devices and second identification data for identifying a storage place where the plurality of energy storage devices is stored;
updating the state data stored by using a state data of the plurality of energy storage devices received from the control devices;
deriving a quality evaluation of each of the plurality of energy storage devices on the basis of the stored state data; and
outputting the derived quality evaluation to the control devices or another device.
